# EUROPEAN PATENT APPLICATION

(11) **EP 1 354 638 A2**
(43) Date of publication of application: **22.10.2003**
(21) Application number: 03008571.6
(22) Date of filing: 14.04.2003
(51) Int. Cl.: B05D 1/26, B41M 5/38

(54) **Method and apparatus for manufacturing pattern members using webs on which coating films have been formed**

(30) Priority: 15.04.2002 JP 2002111839; 26.08.2002 JP 2002245206; 26.08.2002 JP 2002245207; 08.04.2003 JP 2003103900
(71) Applicant: FUJI PHOTO FILM CO., LTD., Kanagawa 250-01 (JP)
(72) Inventor: Takada, Katsuhiko, Fujinomiya-shi, Shizuoka (JP); Nagano, Hideo, Fujinomiya-shi, Shizuoka (JP); Ogawa, Shotaro, Fujinomiya-shi, Shizuoka (JP); Katsumoto, Ryuichi, Fujinomiya-shi, Shizuoka (JP)
(74) Representative: Klunker . Schmitt-Nilson . Hirsch

(57) **Abstract**

In the method for manufacturing pattern members, a plurality of different kinds of materials (P) are formed into the respective patterns on a web (B). In the method, a material transfer sheet (12) on which a material layer (P) for a pattern member has been formed is made in close proximity to the web (B) and to run in such a direction as to intersect the direction of the web (B) running, while allowing the web (B) to run, and at the points where the web (B) and the material transfer sheet (12) intersect, the material layer (P) for the pattern member is transferred from the material transfer sheet (12) to the web (B) with a transferring device (50) so that it is formed into a pattern. Thus, both productivity and product quality are improved in the manufacturing of pattern members.

## Description

### BACKGROUND OF THE INVENTION

### Field of the Invention

The present invention relates to a coating method and coating apparatus for forming coating films, in particular, to a coating method and coating apparatus for coating a continuously running web (a flexible support strip) with various types of liquid compositions to form continuously long and broad coating film faces. The present invention also relates to a method for manufacturing pattern members using flexible support strips (sheets) on which coating films have been formed by the above coating method and coating apparatus, in particular, to a method for manufacturing pattern members suitably used in electronic display applications such as color filters for liquid crystal displays and pixels for organic light emitting diode (OLED) elements.

### Description of the Related Art

In the fields of photosensitive materials and magnetic recording media, the coating process has been adopted in which a continuously running flexible support strip (hereinafter referred to as "web") is coated with a specified coating liquid to form a coating film thereon. In recent years, there have been demands in these fields for a coating technique which permits the production of extremely thin coating films with high thickness accuracy and with smooth surfaces.

The coating apparatuses for coating the surface of a web with coating liquids include, for example, roll coater types, gravure coater types, roll coater plus doctor types, extrusion coater types and slide coater types. In recent years, coating apparatuses of the extrusion coater types have been widely used in these fields, because in such types of coating apparatuses, coating can be performed while feeding a fixed amount of coating liquid with a pump, which makes it easier to obtain a desired film thickness.

As the materials for electronic displays such as color filters for liquid crystal displays and pixels for OLED elements, have been used pattern members of glass substrates, sheet matrices or films on which a fine (at micrometers levels) striped or matrix pattern of any one color or three colors of, for example, red (R), green (G) and blue (B) has been formed.

As the method for manufacturing such pattern members, there have been proposed and employed a variety of methods. They include, for example, photolithography, pigment dispersion method, electrodeposition method and printing method. These methods, however, have advantages and disadvantages, and in the present state, manufacturers employ individual methods which they judge to be the most suitable.

Even if coating apparatuses of extrusion coater types are used, it is very difficult to obtain uniform and large area coating films with thickness after drying 0.1 µm or less. For example, when using coating apparatuses of extrusion coater types, the minimum thickness of the coating film obtained right after the application of a coating liquid is about 20 µm. To obtain coating films with thickness after drying 0.2 µm or less, the concentration of the coating liquids used must be as low as about 1%, and to obtain coating films with thickness after drying 0.1 µm or less, the concentration of the coating liquids used must be as low as about 0.5%; thus, the coating liquids used should be very thin. Because such thin liquids have low viscosities, it is very difficult to apply them uniformly and dry the applied coatings to a uniform thickness.

The coating films having low concentrations and viscosities are likely to be affected by the airflow at the time of drying, therefore, it is desired to control the airflow rate as low as possible, whereas if the airflow rate is low at the time of drying, it takes more time to dry the coating films, causing a problem of low productivity.

As to the manufacturing of pattern members, in the present state, it is hard to satisfy both the quality (pattern accuracy) and cost requirements with the above-described conventional methods for manufacturing pattern members.

Specifically, the photolithography, the deposition method, etc. (refer to, for example, Japanese Patent Application Publication Nos. 2000-36385 and 9-204984) not only require many man-hours and complex equipment, but also are unsuitable for processing on a continuous flexible support and unfit for mass production.

In the gravure offset printing method (refer to, for example, Japanese Patent Application Publication No. 62-85202), there arise problems of pattern form disruption at the time of transfer and difficulty in highly accurate (at several tens micrometers levels) processing. The method is unfit for making films of larger area, and moreover, its capability of providing uniform ink thickness and alignment accuracy is problematic.

The ink-jet method (refer to, for example, Japanese Patent Application Publication No. 10-153967) has not only a problem of decreasing aperture ratio because it requires partition walls, but also a problem of having difficulty in making an organic layer into multiple layers. Further, the method is unfit for making films of larger area, and moreover, its capability of providing uniform ink thickness is problematic.

The relief dyeing process, the pigment dispersion method and the electrodeposition method all have a problem of requiring many man-hours, therefore, being unfit for mass production.

The transfer method (refer to, for example, Japanese Patent Application Publication No. 2000-246866) is a technique for transferring patterns having been formed on a film to glass substrates etc.; however, the method cannot deal with transferring patterns to a substrate in continuous film form.

The other forms of the transfer method (refer to, for example, Japanese Patent Application Publication No. 8-171008) include, for example, a technique for transferring patterns on substrates in continuous film form. However, this technique is to transfer a color set film first to the surface of a plate and then to a substrate in film form etc. Thus, the technique requires repeating the transferring process, which causes problems of, for example, low yield and variation in pattern adhesion.

### SUMMARY OF THE INVENTION

The present invention has been made in light of the above-described situation. Accordingly, an object of the present invention is to provide a coating method and coating apparatus for forming a coating film of a specified thickness, while feeding a coating liquid through a slit of a coating head, on a flexible support strip (web) continuously carried at a fixed distance apart from the coating head, the method and apparatus being capable of producing an extremely thin film with high thickness accuracy and with a smooth surface.

Another object of the present invention is to provide a method for manufacturing pattern members which comprise a substrate and patterns of a plurality of kinds of different materials formed on the substrate, the method being capable of improving both productivity and product quality (pattern accuracy).

To accomplish the above objects, the present invention provides: a coating method for forming a coating film of a specified thickness, while feeding a coating liquid through a slit of a coating head, on a flexible support strip continuously carried at a fixed distance apart from the coating head, and subsequently drying the coating film formed on the substrate strip, the method being characterized in that the thickness of the coating film right after the application of the coating liquid is set for 2 to 40 µm and the relative airflow rate on the surface of the coating film is set for 0.2 m/sec or less until the viscosity of the coating liquid becomes 100 mPa·s; and a coating apparatus equipped with a drying device which is used in the above method.

According to the present invention, since the thickness of the coating film right after the application of the coating liquid is kept in a proper range and the relative airflow rate on the surface of the coating film is kept at 0.2 m/sec or less until the viscosity of the coating liquid becomes a specified value, an extremely thin film with high thickness accuracy and with a smooth surface can be obtained.

After repeating an intensive investigation, the inventors of the present invention gave attention to the drying conditions of a coating liquid right after its application on a web until its viscosity becomes a certain value, and the present invention was accomplished when the inventors found how to keep the drying conditions optimal. To keep the conditions optimal, a drying device which can avoid airflow must be introduced.

The reason that "the relative airflow on the surface of the coating film" is specified in this specification is that even if the airflow rate within a drying device is kept at 0.2 m/sec or less, the relative airflow rate between the surface of the coating film and the airflow can be 0.2 m/sec or more depending on the carrying speed of the flexible support strip. Specifically, even if the airflow rate within a drying device is kept at 0, when the carrying speed of the flexible support strip is 0.2 m/sec, the relative airflow rate on the surface of the coating film becomes 0.2 m/sec.

While there have been proposed various techniques for coating a web with liquids having low viscosities, none of them has accomplished a concept and advantages equivalent to those of the present invention. For example, the technique proposed in Japanese Patent Application Publication No. 2000-157923 specifies the airflow rate before the web enters the drying zone; however, it does not mention other drying conditions, in which it is different from the present invention.

Further, the technique proposed in Japanese Patent Application Publication No. 2000-329463 is common to the present invention in that it specifies the airflow rate within a fixed time after the application of a coating liquid; however, it specifies that the thickness of the coating film right after the application of a coating liquid is 50 µm or more, in which it is different from the present invention.

The technique proposed in Japanese Patent Application Publication No. 10-68587 only specifies the direction of airflow of drying air, thus it is different from the present invention.

The present invention provides: a coating method for forming a coating film of a specified thickness, while feeding a coating liquid through a slit of a coating head, on a flexible support strip continuously carried at a fixed distance apart from the coating head, the method being characterized in that the average flow rate of the coating liquid in the slit of the coating head is set for 100 to 500 mm/sec, the thickness of the coating film right after the application of the coating liquid is set for 2 to 40 µm, and the flexible support strip is held in a horizontal position within 0.5 seconds after the application of the coating liquid; and a coating apparatus which is used in the above method.

According to the present invention, since the average flow rate of the coating liquid in the slit of the coating head is kept in a proper range and the web is held in a horizontal position within a short time after the application of the coating liquid, an extremely thin film with high thickness accuracy and with a smooth surface can be obtained.

After repeating an intensive investigation, the inventors of the present invention found that if the average flow rate of the coating liquid in the slit of the coating head is not satisfactorily high, the coating liquid does not flow uniformly in the width direction of the web and if the average flow rate is too high, the coating liquid is fed in such a manner as to be ejected from the slit of the coating head, the coating liquid does not flow stably.

Further, the inventors found that if the elapsed time after the instance of applying the coating liquid on the web until the web is held in a horizontal position is too long, the liquid applied on the web flows on the same, causing non-uniform coating.

While there have been proposed various techniques for coating a web with liquids having low viscosities, none of them has accomplished a concept and advantages equivalent to those of the present invention. For example, the techniques proposed in Japanese Patent Application Publication Nos. 10-290946 and 11-207230 are to make the slit interval of the coating head very narrow so that coating is performed in such a manner as to eject the coating liquid from the slit. With these techniques, the coating liquid does not flow stably, which makes it difficult to obtain a coating film of uniform thickness. The object of these techniques is to prevent foreign matters from being entrapped on the coating film; in this respect, they are different from the present invention.

The technique proposed in Japanese Patent Application Publication No. 2001-906 specifies the shape of the inside of the coating head so that the inertia force is restricted when a coating liquid is fed from the side surface of the coating head and the coating liquid can flow uniformly in the width direction of a web. This is different from the present invention in both object and concept.

The average flow rate of the coating liquid in the slit of the coating head can be obtained by dividing the flow amount of the coating liquid fed to the coating head by the section area of the slit.

In the present invention, preferably the viscosity of the coating liquid is 10 mPa·s or less. The advantages of the present invention are effectively provided when using coating liquids having such low viscosities.

In the present invention, preferably the coating liquid contains an organic solvent. The advantages of the present invention are effectively provided when using coating liquids containing an organic solvent.

In the present invention, preferably the thickness of the coating film after drying is 0.01 to 0.4 µm. The advantages of the present invention are effectively provided in the coating method for forming a coating film whose thickness after drying is very thin.

In the present invention, preferably the drying device includes at least one of a heater-heating drying device, a roller-heating drying device, a vacuum drying device and a low-humidity-atmosphere drying device. With these drying devices, satisfactory drying speed can be obtained, even if the relative airflow rate on the surface of the coating film is kept in a specified range.

The present invention provides a method for manufacturing pattern members which uses flexible support strips on which the respective coating films have been formed by the above-described coating method and in which a plurality of different kinds of materials are formed in patterns on a substrate, the method being characterized in that it includes: a step of applying different kinds of materials on the respective flexible support strips prepared for the materials; a step of drying the flexible support strips on which the respective materials have been applied; and a step of repeating the operation, for every material, of superposing one of the flexible support strips on the substrate in such a manner as for the material having been applied on the support strip to be in opposition to the substrate and pushing the flexible support strip from its back with a push plate so as to transfer the material to the substrate in a pattern, so that the plurality of different kinds of materials are formed in patterns on the substrate.

According to the present invention, first, a plurality of different kinds of materials (R, G and B) are applied on the respective flexible support strips (transfer sheets) for red (R), green (G) and blue (B) and the transfer sheets are dried. Then, if one of the transfer sheets is superposed on a substrate, which is to be a product, in such a manner as for the material on the sheet to be in opposition to the substrate and the transfer sheet is pushed from its back with a push plate, the material can be transferred to the substrate in a pattern. If this operation is repeated for every material (R, G and B), a pattern member (e.g. OLED element, color filter for liquid crystal display) can be formed.

When intending to transfer a material to a substrate in a pattern, if the material is superposed on the substrate via a mask material, which has almost the same shape of openings as that of the desired pattern, in such a manner as for the material to be in opposition to the substrate and the transfer sheet is pushed from its back with a push plate, the material is transferred to the substrate through the openings of the mask material in a pattern.

Accordingly, the above method of the present invention can improve both the productivity and the product quality (pattern accuracy) in the manufacturing of pattern members in which a plurality of different kinds of materials are formed in patterns on substrates. Further, the method provides the advantage of high degree of freedom in selecting the kinds of materials (ink).

Although the invention specifies "push the transfer sheet from its back with a push plate", if the method is constructed so that the substrate is pushed from its back in such a manner as to be pushed against the push plate, the material can also be transferred to the substrate in a pattern. Accordingly, this construction is also included in the scope of the present invention.

The present invention provides: a method for manufacturing pattern members in which a plurality of different kinds of materials are formed in patterns on a substrate, the method being characterized in that it includes: a step of applying the different kinds of materials on the respective plates on which the patterns for the respective materials have been formed; a step of drying the plates having the materials applied on their surfaces; and a step of repeating, for every material, the operation of superposing and positioning one of the plates on the substrate in such a manner as for the pattern to come in contact with the substrate and pushing the substrate and/or the plate from their backs to transfer the pattern to the substrate, so that the different kinds of materials are formed in patterns on the substrate; and an apparatus used in the above method.

According to the present invention, different kinds of materials (R, G and B) are applied in patterns on the respective plates on which patterns for red (R), green (G) and blue (B) have been formed and the plates are dried. Then, if one of the plates is superposed on a substrate, which is to be a product, in such a manner as for the pattern on the plate to come in contact with the substrate and positioned, and if the substrate and/or the plate are pushed from their backs, the material in a pattern can be transferred to the substrate. If this operation is repeated for every material (R, G and B), a pattern member (e.g. OLED element, color filter for liquid crystal display) can be formed.

Accordingly, the above method of the present invention can improve both the productivity and the product quality (pattern accuracy) in the manufacturing of pattern members in which a plurality of different kinds of materials are formed in patterns on substrates.

In the present invention, preferably the above push plate or the plate has protrusions formed in a pattern on its surface. If the push plate has protrusions formed in a pattern on its surface, the materials are easily and reliably formed in specified patterns on the transfer sheets.

The push plates or the plates on which the respective patterns for different materials have been formed are not necessarily relief plates, but they may be flat plates such as PS plates, as long as they have patterns for different materials formed thereon and, when applying materials on the plates with a coating device, the materials can be formed in specified patterns on the plates.

In the present invention, preferably the substrates are flexible support strips. If the substrates are flexible support strips (e.g. flexible films), the substrates are easy to carry, which provides good productivity. Further, if the substrates are flexible support strips, they can be used in a variety of applications such as OLED elements.

In the present invention, preferably the plates are used repeatedly by cleaning/drying the same after the pattern materials are transferred to the substrate. If the plates can be used repeatedly, not only the cost of equipment but also the space for stocks can be decreased, which are desirable in terms of productive facilities.

### BRIEF DESCRIPTION OF THE DRAWINGS

The nature of the present invention, as well as other objects and advantages thereof, will be explained in the following with reference to the accompanying drawings, in which like reference characters designate the same or similar parts throughout the figures and wherein:
Fig. 1 is a schematic representation of a coating apparatus embodying the present invention;
Fig. 2 is a schematic representation, partially broken away, showing a coating head;
Fig. 3 is an enlarged view of the main part of Fig. 1;
Figs. 4(a) to 4(d) are schematic flowcharts of a method for manufacturing pattern members embodying the present invention;
Figs. 5(a) and 5(b) are block diagrams of the pattern member embodying the present invention;
Fig. 6 is another schematic flow chart of a method for manufacturing pattern members embodying the present invention;
Fig. 7 is a schematic flow chart of a method for manufacturing pattern members embodying the present invention;
Fig. 8 is a schematic view showing the layout of an apparatus for manufacturing pattern members embodying the present invention;
Fig. 9 is a block diagram of a drying device which dries plates;
Fig. 10 is a block diagram of a transferring device;
Fig. 11 shows chemical formulas of the compounds as constitutes of pattern materials; and
Fig. 12 shows a chemical formula of the compound as a constituent of pattern materials.

### DETAILED DESCRIPTION OF THE PREFERRED EMBODIMENTS

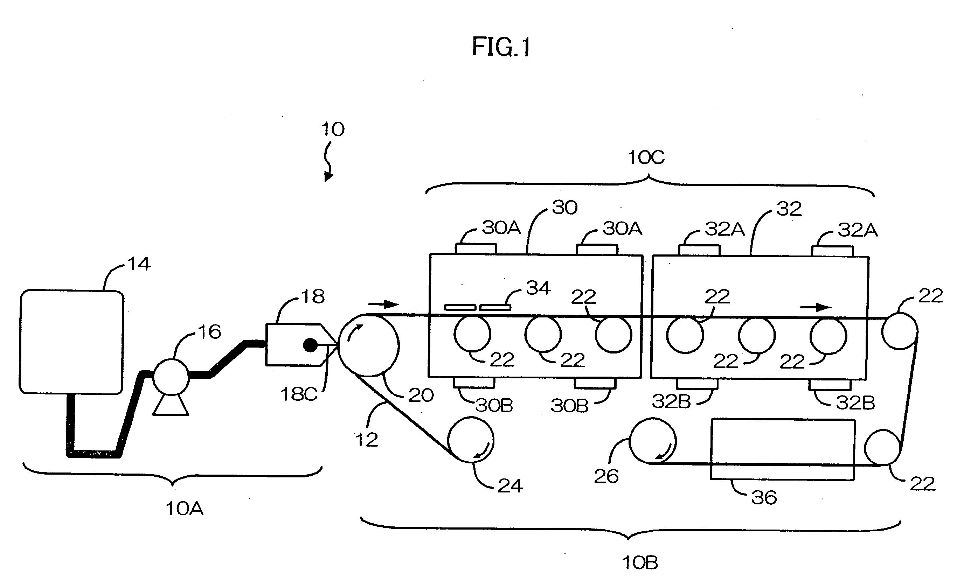

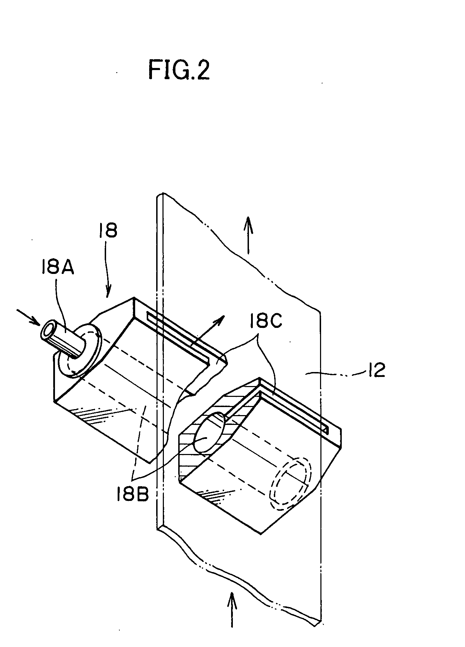

In the following a preferred embodiment of a coating method and apparatus of the present invention will be described in detail with reference to the accompanying drawings. Fig. 1 is a schematic representation of a coating apparatus 10 embodying the present invention and Fig. 2 is a schematic representation, partially broken away, showing a coating head 18.

As shown in Fig. 1, the coating apparatus 10 comprises a coating device 10A which coats a web 12 with a coating liquid, a carrying device 10B which continuously carries the web 12, and a drying device 10C which dries the coating liquid having been applied on the web 12.

The coating device 10A is made up of a coating liquid tank 14, a pump 16 which pumps the coating liquid out of the coating liquid tank 14, a coating head 18 which coats the web 12 with the coating liquid pumped through the pump 16, and piping which connects the above constituents.

As the pump 16, preferably a metering pump is used because it can stabilize the flow rate of the fed coating liquid. As a metering pump, various types of pumps, for example gear pump and roller pump, can be used; however, for the coating in the present invention a gear pump can be used particularly suitably.

The coating head 18 is positioned with its tip in close proximity to and in opposition to the continuously running web 12. As shown in Fig. 2, within the coating head 18, a cylindrical pocket portion 18B is formed in parallel with the width direction of the web 12, and the coating pocket portion 18B is connected to a feed line 18A. Within the coating head 18, a coating slit 18C having its discharge port at the tip of the coating head is also formed, and the coating slit 18C is in communication with the coating pocket portion 18B.

The coating slit 18C is a narrow flow pass that connects the pocket portion 18B and the tip of the coating head and extends in the width direction of the web 12. A desired amount of coating liquid to be applied on the web 12 is fed from the feed line 18A into the coating pocket portion 18B of the coating head 18.

While Fig. 2 shows one type of pumping method in which the coating liquid is fed into the coating pocket portion 18B from one side of the same, there are other types: for example, a type in which the coating liquid is fed from one side of the coating pocket portion 18B and drawn out from the other side of the same; and a type in which the coating liquid is fed from the mid-portion of the coating pocket portion 18B and allowed to flow towards both sides of the same. Any one of the above types may be applied to the present invention.

The coating head 18 used in the present invention is not limited to an extrusion type, and any types of coating heads can be used as long as they are constructed so that the coating liquid can be fed through their slits and applied on the web 12.

The carrying device 10B is made up of an unwind roller 24 which unwinds the web 12 in the wound state, a back-up roller 20 which is provided opposite the coating head 18 and backs up the web 12 at the time of coating, a plurality of guide rollers 22, 22, ... which tension the web 12 and help carry the continuously running web 12, and a wind-up roller 26 which winds up the web 12. The web 12 is continuously carried at a fixed speed by driving any one of the above rollers with a certain rotational speed.

A tension roller which controls the tension of the web 12 and a driving roller which controls the carrying of the web 12 can also be provided arbitrarily, though they are omitted in the drawing.

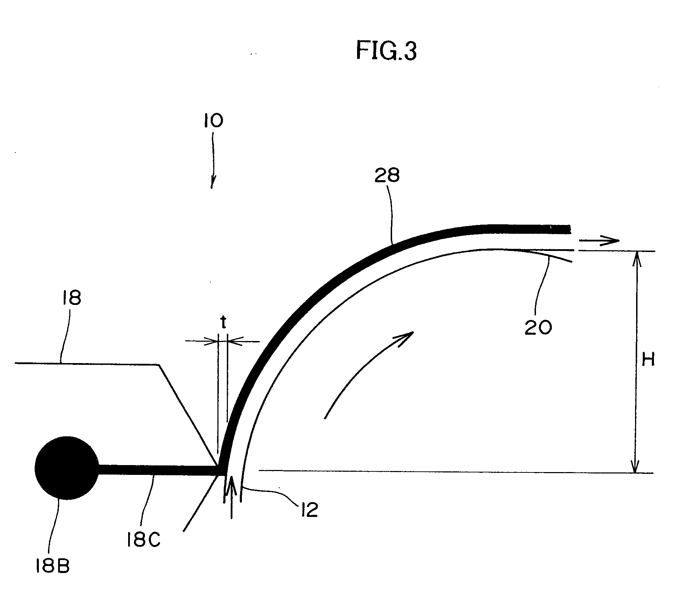

As shown in Fig. 3, the coating apparatus 10 is constructed so that the tip of the coating head 18 is in opposition to the "9-o'clock" position of the back-up roller 20 in a clockwise sense. Then, the distance t between the tip of the coating head 18 and the surface of the web 12 is established. As shown in the same drawing, the web 12 on which the coating liquid has been applied by the coating head 18 has a coating film 28 formed on its surface and is carried clockwise with its back backed up by the back-up roller 20.

The web 12 is controlled so that it is carried from the position at the time of the application of the coating liquid (9-o'clock position) to a horizontal position (12-o'clock position) within 0.5 seconds. Controlling the web 12 in this manner prevents the coating liquid having been applied on the web from flowing in the direction of gravity and the coating non-uniformity from occurring.

The position of the tip of the coating head 18 is not necessarily limited to the 9-o'clock position of the back-up roller 20 in a clockwise sense. The position is arbitrarily selected as long as it ensures uniform coating and allows the web 12 to be carried to a horizontal position (12-o'clock position) within 0.5 seconds.

However, if the tip of the coating head is provided at a rather lower position (e.g. 7-o'clock position), the coating liquid having been applied on the web 12 might flow down on the web by gravity, whereas if the tip of the coating head is provided at a rather upper position (e.g. 11-o'clock position), the coating liquid might not be applied on the web stably and uniformly.

The outside diameter of the back-up roller 20 is not limited to any specific one, and it is arbitrarily selected as long as it ensures uniform coating. Preferably, the outside diameter of the backup-roller 20 is such that it allows the web 12 to be carried to a horizontal position within 0.5 seconds. Instead of the back-up roller 20 shown in the drawing, arranging a plurality of smaller diameter back-up rollers in the circumference of a circle can also be adopted.

As the drying device 10C shown in Fig. 1, tunnel-like driers 30 and 32 are provided. In the downstream of the drier 32 is provided a temperature/humidity controlling zone 36. In the inside of the driers 30 and 32, the web 12 is supported by the above-described guide rollers 22, 22, ....

The drier 30 as an earlier stage of the drying device 10C is constructed so that the internal airflow rate is 0. Specifically, in the present invention, it is preferable that the relative airflow rate on the coating film surface is 0.2 m/sec or less until the viscosity of the coating liquid becomes 100 mPa·s, and the drier 30 is constructed so that it meets this requirement. In more particular, a plurality of shielding plates (not shown in the drawing) are provided in the direction perpendicular to the direction of the carrying of the web 12, and in addition, infrared heaters 34, 34 are provided in proximity to the web 12.

As other constituents, exhaust vents 30B, 30B are provided on the bottom of the drier 30 because the organic solvent, moisture content, etc. in the coating liquid should be exhausted, and intake vents 30A, 30A are also provided on the top of the drier 30 in such a manner as to correspond to the exhaust vents. Shielding plates (not shown in the drawing) are provided to avoid the effects of the disturbance caused by the airflow passing through the above vents.

When adopting these constructions, the sensor portion of a hot-wire anemometer was arranged at the position of carrying the web 12, and while measuring the airflow rate, the optimum construction was pinpointed by trial and error. Further the portion between the coating head 18 and the drier 30 was enclosed with a cover (not shown in the drawing) so that the coating film was not affected by the airflow.

Even if the airflow rate in the inside of the drier 30 is 0, the relative airflow rate is caused by the carrying of the web 12, as described above. For example, if the carrying speed of the web 12 is 10 m/min, the airflow rate becomes 0.167 m/sec. Accordingly, if the carrying speed of the web 12 is set for 12 m/min or higher, the relative airflow rate becomes 0.2 m/sec or higher. Thus, in such a case, the construction is required which causes an airflow flowing in the direction parallel with the direction of carrying the web 12.

The construction of the drying device 10C of this embodiment assumes that the viscosity of the coating liquid becomes 100 mPa·s before the web 12 reaches the outlet of the drier 30; therefore, the length of the drier 30 should be optimally designed depending on the composition of the coating liquid, the viscosity of the coating liquid (stock solution), the thickness of the coating film, the speed of carrying the web 12 and the specification (power) of the infrared heaters 34, 34.

As the drying devices provided for the drier 30, the infrared heaters 34, 34 are employed; however, the devices are not limited to the above heaters, and various types of known drying devices, such as other kinds of heater-heating drying devices, roller-heating drying devices, vacuum drying devices and low-humidity-atmosphere drying devices, can also be employed as long as the coating liquid applied on the web 12 can be dried uniformly.

The roller-heating drying devices herein mentioned are constructed so that they have a plurality of guide rollers 22, 22,... arranged closely adjacent to each other and heating devices provided for the rollers. Various types of constructions can be employed; for example, as an internal heating device, one in which heat medium is passed through the inside of the guide rollers 22 and, as an external heating device, one in which heaters are arranged on the bottom side of the guide rollers 22.

In the drier 32 as a middle stage of the drying device 10C, the airflow rate in its inside is not limited, unlike the drier 30. The reason is that the construction of the drying device 10C assumes that the viscosity of the coating liquid becomes 100 mPa·s or more before the web 12 reaches the inlet of the drier 32; therefore, even if the relative airflow rate is high, the coating film formed is less affected. However, it is preferable that the airflow rate is 10 m/sec.

Thus, for the drier 32 various types of known drying devices can be employed. In the construction shown in the drawing, a circulation type of drying device is employed. In the dryer 32, exhaust vents 32B, 32B are provided on the bottom of the drier 32 and intake vents 32A, 32A are provided on the top of the drier 32 in such a manner as to correspond to the exhaust vents.

The temperature/humidity-controlling zone 36 as a later stage of the drying device 10C is provided to control the temperature/humidity (moisture content) of the web 12 after drying, and various types of known constructions can be employed.

Then the formation of a coating film using the coating apparatus 10 will be described. In the formation of a coating film, a coating liquid which has a viscosity of 10 mPa·s or less and contains an organic solvent is preferably used.

As the web 12, can be used flexible strips of fixed width, fixed length and thickness about 2 to 200 µm which comprise: plastic films such as polyethylene terephthalate (PET), polyethylene-2,6-naphthalate, cellulose diacetate, cellulose triacetate, cellulose acetate propionate, polyvinyl chloride, polyvinylidene chloride, polycarbonate, polyimide and polyamide; paper; paper coated with or laminated to α-polyolefins with 2 to 10 carbons such as polyethylene, polypropylene and ethylene-butene copolymer; or metal plates, or strips which comprise the above flexible strips, as a base material, and processed layers formed on the base materials.

In the coating apparatus 10, coating is performed, while unwinding the web 12 through the unwind roller 24, in such a manner as to control the flow rate of the pump 16 so that the average flow rate of the coating liquid in the slit 18C of the coating head 18 becomes 100 to 500 mm/sec, control the speed of carrying the web 12 so that the thickness of the coating film 28 right after the application of the coating liquid becomes 2 to 40 µm, and hold the web 12 in a horizontal position (12-o'clock position) within 0.5 seconds after the application of the coating liquid.

In the drying process after the application of the coating liquid, the drier 30 is controlled so that the relative airflow rate on the surface of the coating film becomes 0.2 m/sec or lower and adjusted so that the viscosity of the coating liquid becomes 100 mPa·s before the web 12 reaches the outlet of the drier 30. The drier 30 is set so that a coating film with high thickness accuracy and with smooth surface is obtained.

The web 12 having passed through the drier 32 and the temperature/humidity-controlling zone 36 is wound up around the wind-up roller 26.

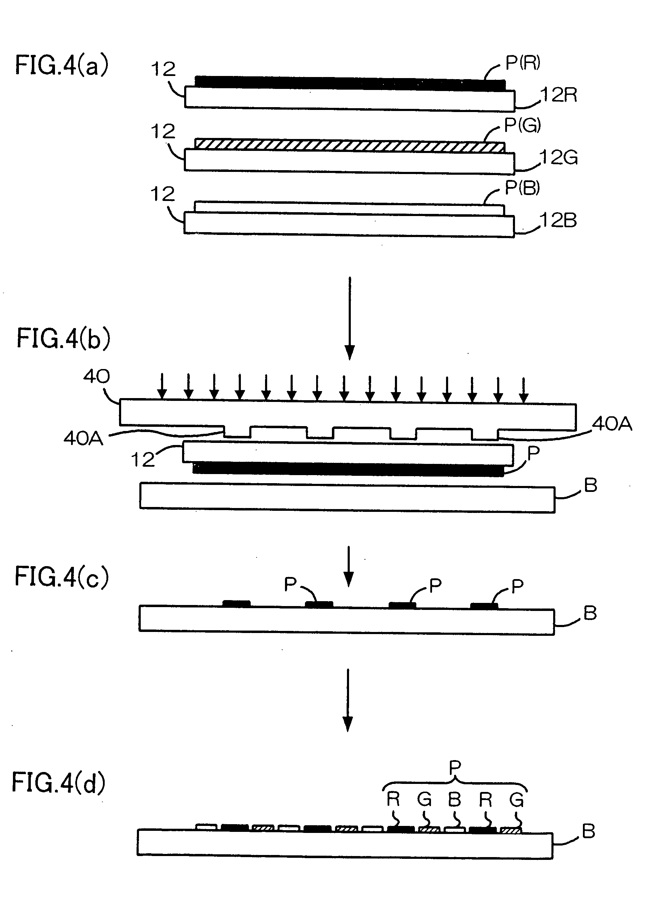

In the following, a preferred embodiment of a method for manufacturing pattern members using flexible support strips on which coating films have been formed by the coating method and apparatus of the present invention will be described in detail with reference to the accompanying drawings. In Figs. 4(a) to 4(d), a process flow chart of a method for manufacturing pattern members embodying the present invention is shown by way of example.

In this embodiment, as transfer sheet as several types of webs (flexible support strips) 12, three types of transfer sheets: a transfer sheet 12R for red (R), a transfer sheet 12G for green (G), and a transfer sheet 12B for blue (B) are used as shown in Fig. 4(a). For the transfer sheets 12, materials in sheet form can be used which have a specified shape, can be coated with several types of materials (pattern materials) P, and allow the materials P to be transferred to a substrate B in the transfer process. In other words, the materials for the transfer sheets are required to be inferior to the material of the substrate B in wettability or adhesive properties by the materials P under the conditions in the transfer process. As such transfer sheets 12, the aforementioned webs can be used.

Application of the materials P on the transfer sheets 12 is performed with the coating apparatus 10. A single coating apparatus 10 may be used to apply several types of pattern materials P, or a single coating apparatus 10 may be provided for each pattern material P. As described above, the system of the coating apparatus 10 does not matter as long as it can apply the pattern materials P on the transfer sheets 12 to a fixed thickness. The transfer sheets 12 on which the pattern materials P have been applied are sent to the drier (drying device) 30 so that the pattern materials P are dried.

Preferably, the above-described sequence of processes are carried out under the environmental conditions of satisfactory dust-freedom and optimum temperature/humidity. Accordingly, it is preferable to carry out the processes in a clean room, and it is particularly preferable to position the coating device 10A and the drying device 10C in the environment of cleanliness class 100 or less. To accomplish this, the method can employ a down flow clean room or a clean bench.

Particularly when the pattern materials P are used for luminescent layers of OLED, it is preferable to hold them in a low-humidity environment since the product life of the luminescent layers is largely affected by moisture. In particular, it is preferable to hold them in air or in a nitrogen gas atmosphere at minus 20°C or lower. It is also preferable to decrease the relative humidity (RH) as much as possible.

In the transfer process shown in Fig. 4(b), the pattern material P is transferred to the substrate B in the steps of: superposing one of the transfer sheets 12 on the substrate B so that the pattern material P is in opposition to the substrate B; and pushing the transfer sheet 12 from its back with a push plate 40.

As the material for the substrate B fed in this transfer process, a glass plate (for, for example, color filters of liquid crystal displays), a silicon substrate, a metal plate, etc. can be used. A flexible support strip can also be used for the substrate B.

As the substrate B of a flexible support strip, can be used a flexible strip of fixed width, length 45 to 20,000 m and thickness 2 to 200 µm which comprises: plastic films such as polyethylene terephthalate (PET), polyethylene-2,6-naphthalate, cellulose diacetate, cellulose triacetate, cellulose acetate propionate, polyvinyl chloride, polyvinylidene chloride, polycarbonate, polyimide and polyamide; paper; or paper coated with or laminated to α-polyolefins with 2 to 10 carbons such as polyethylene, polypropylene and ethylene-butene copolymer, or a strip which comprises the above flexible strip, as a base material, and a processed layer formed on the base material.

As the push plate 40, is used a plate member on the surface of which protrusions 40A, 40A, ... are formed to almost the same shape as that of the pattern. The protrusions 40A are arranged on the push plate 40 so that they correspond to the pattern of each of the materials (R, G, B, etc.). The size of the protrusions 40A should be almost the same as that of the pattern. In particular, for example, when the pattern is a rectangle 100 × 200 µm, the size of the protrusions 40A is the same as the rectangle.

For the step of the protrusions 40A on the push plate 40, though the optimum value can be employed depending on the size, thickness and required accuracy of the pattern, generally preferably the step of 30 to 70 µm can be employed. From the viewpoint of the required accuracy of the pattern, in other words, of the forming accuracy of the protrusions 40A, it is preferable to make the step of the protrusions 40A as small as possible; but on the other hand, from the viewpoint of the transfer performance, it is preferable to make the step of the protrusions 40A somewhat large.

Preferably, such a push plate 40 is formed of a metal member with thickness of a certain value or more. The protrusions 40A of the push plate 40 can be formed by photoetching etc.

When aligning the substrate B and the push plate 40 in the X, Y, Z and θ directions, alignment devices commonly in use, for example devices constructed as a combination of a ball screw with a stepping motor, can be employed. A positioning detecting device for the substrate B and the push plate 40 can be constructed by combining a microscope or a digital camera with a CRT monitor connected thereto.

As a pushing device which pushes the push plate 40, can be employed pushing devices commonly in use, for example, devices constructed as a combination of an air cylinder with a regulator to push the entire face of the push plate 40 at a time. Instead of using devices which are constructed to push the entire face of the push plate 40 at a time, a pushing method can also be employed which uses roller members to push the push plate 40 serially or linearly. In other words, devices can be used which are constructed to move roller members while pushing the push plate 40 from its back with the roller members.

Preferably the push plate is constructed so that, when transferring the pattern material P, it can apply a specified pressure to the pattern material P depending on the shape and the material thereof and also apply a specified heat to the same depending on the situation. For example, a push plate can be employed which is constructed to have a sheath heater, as a heating device, in its inside.

At a time when the alignment is completed, if the push plate 40 is pushed from its back with a pushing device, the pattern material P is transferred to the substrate B. This state is shown in Fig. 4(c). If this operation is repeated, for example, three times for three colors R, G and B, the substrate B shown in Fig. 4(d) is formed.

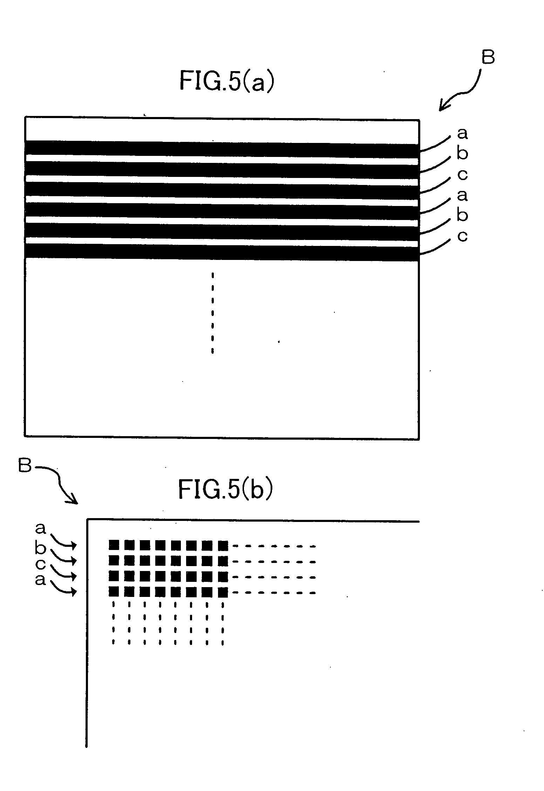

When the pattern is designed to give stripes, a striped pattern of a, b, c, a, b, c, ... as shown in Fig. 5(a) is formed on the substrate B. When the pattern is designed to give a matrix, a matrix pattern of a, b, c, a, b, c, ... as shown in Fig. 5(b) is formed on the substrate B.

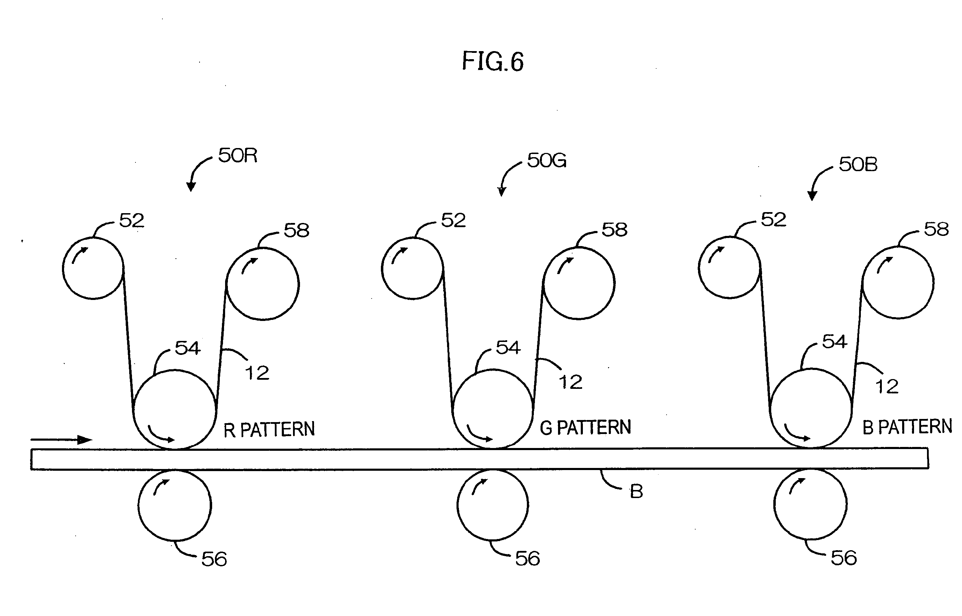

Then, another preferred embodiment of a method for manufacturing pattern members of the present invention will be described in detail. In Fig. 6, construction of another method for manufacturing pattern members embodying the present invention is shown by way of example. In this embodiment, a plurality of transferring devices 50 are provided on the carrying path of the substrate B and patterns for three colors R, G and B are formed consecutively in a sequence of processes.

In each of the transferring devices 50R, 50G and 50B, a transfer sheet 12 unwound from an unwind roller 52 is wound up around a push roller 54, which has patterned protrusions (not shown in the drawing) formed on its surface, and caught between the push roller 54 and a back-up roller 56 while being in contact with the substrate B, wherein the pattern material P is transferred to the substrate B with the help of the protrusions of the push roller 54. Subsequently after this, the transfer sheet 12 is wound up around a wind-up roller 58.

Like the preceding embodiment, preferably the transferring devices are so constructed that a properly specified pressure and a specified heat, depending on the situation, can be applied at the time of transferring. The pattern materials P (materials for three colors R, G and B) are transferred to the substrate B in this manner.

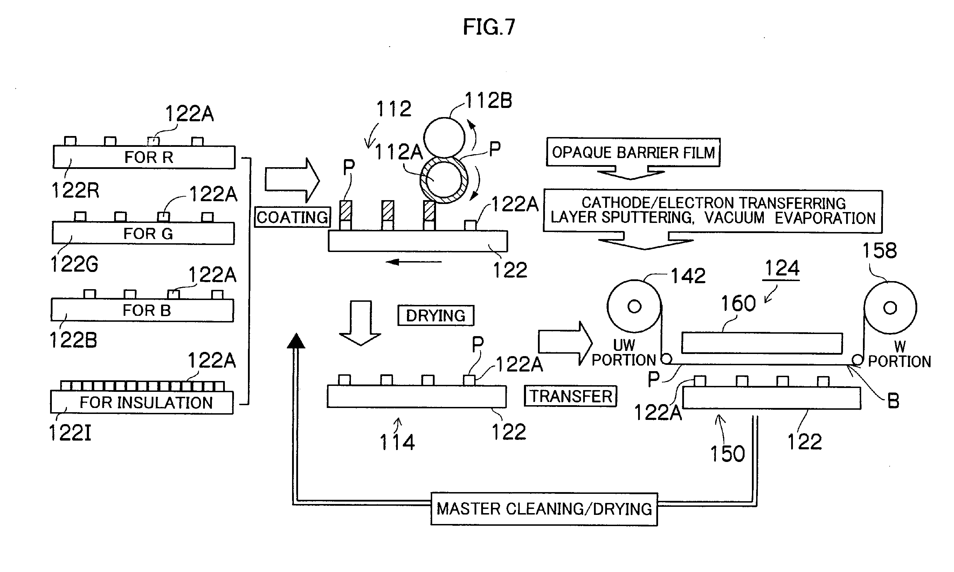

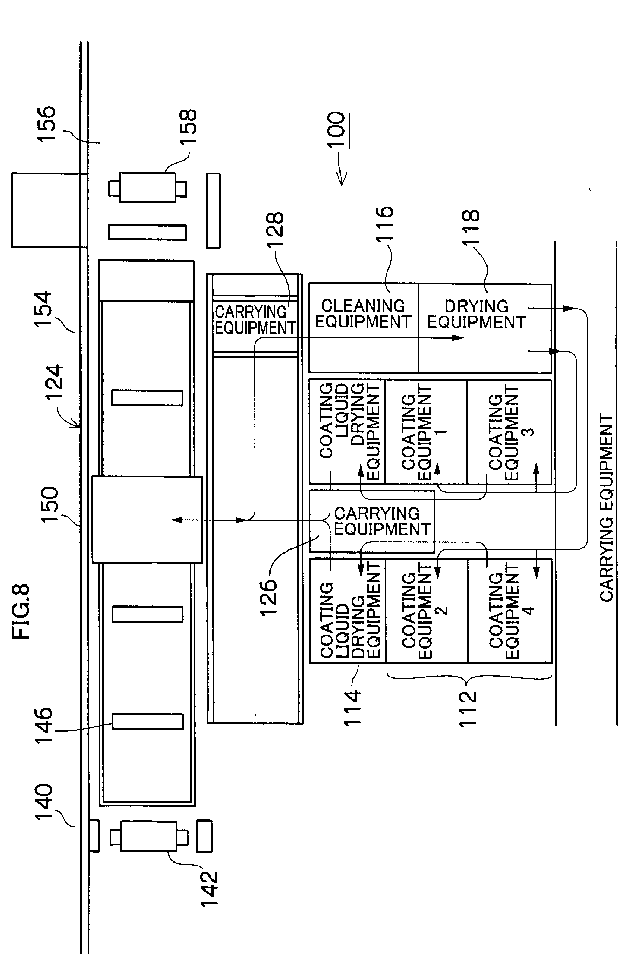

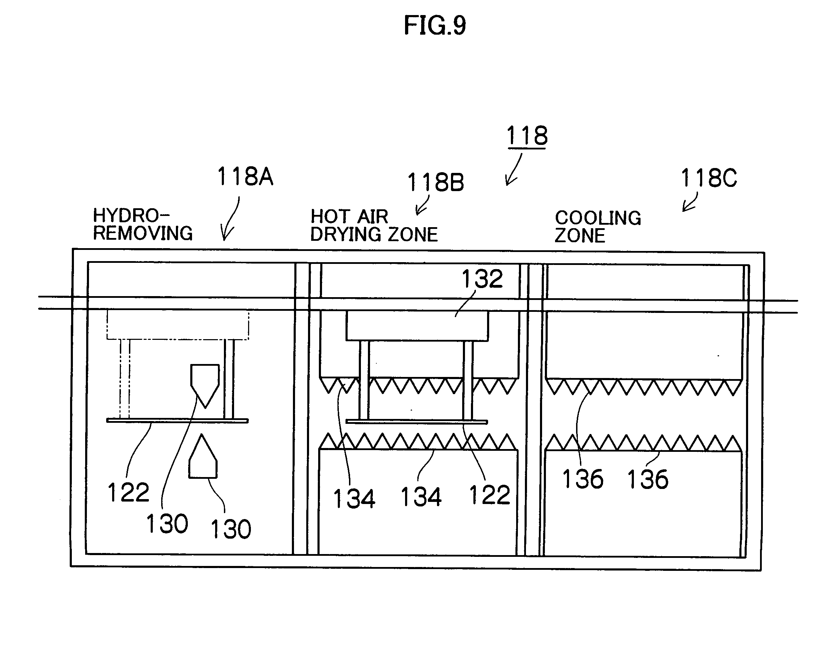

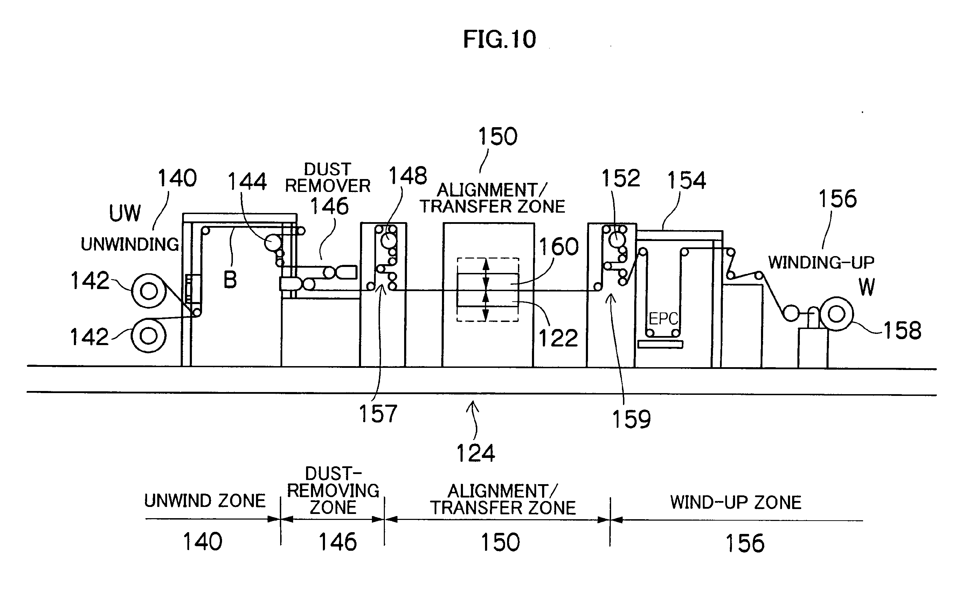

Then, still another preferred embodiment of a method for manufacturing pattern members of the present invention and a preferred embodiment of an apparatus for manufacturing the same will be described in detail. In Fig. 7, a process flow chart of a method for manufacturing pattern members embodying the present invention is shown by way of example. In Figs. 8 to 10, schematic views of an apparatus for manufacturing pattern members embodying the present invention are shown. Fig. 8 is a plan view showing the layout of the apparatus 100 for manufacturing pattern members. A block diagram of a drying device which dries plates (plate drying equipment) 118 of the apparatus 100 for manufacturing pattern members and a block diagram of a transferring device 124 of the same are shown in Figs. 9 and 10, respectively.

In this embodiment, as various types of plates 122, four types of plates: a plate for red (R) 122R, a plate for green (G) 122G, a plate for blue (B) 122B and a plate for an insulation layer (I) 122I are used as shown in Fig. 7. Relief plates are used for the various types of plates 122. In each of the relief plates, the initial pattern alone is formed in relief. Accordingly, when intending to apply a variety of different materials (pattern materials) P to the plates 122 with a coating device 112, the pattern materials P are applied only on pattern portions 122A and patterns are formed only on the same portions.

Even if the variety of different materials (pattern materials) P are applied/formed not only on the pattern portions 122A, but on the portions other than the pattern portions 122A when applying the same to the plates 122 with the coating device 112, it does not matter as long as the pattern materials P can be transferred, in a transferring device 124 described later, to the substrate B to form patterns thereon.

This is true, for example, when the pattern materials P are applied/formed on the portions other than the pattern portions 122A, but afterwards the thickness of the pattern materials P is decreased in the drying process and the pattern materials P alone are formed into patterns on the substrate B in the transferring device 124.

On the various types of plates 122, alignment marks are formed, if needed, which are used in the alignment in the transfer process described later.

As materials for the plates 122 as relief plates, glass plates, silicon substrates, metal plates, etc. can be used. As methods for forming the pattern portions 122A as the relief portions on the plates 122, various known methods, such as photolithography, machining, electrical discharge machining and laser beam machining, can be employed depending on the materials of the plates 122, the shape of the pattern portions 122A, etc.

Prior to manufacturing pattern members, cleaning/drying of the various types of plates 122 are performed. In other words, in this embodiment, the various types of plates 122 can be used repeatedly if they are cleaned and dried. Thus, the apparatus 100 for manufacturing pattern members is provided with plate cleaning equipment (a plate cleaning device) 116 and plate drying equipment (a plate drying device) 118.

As the plate cleaning equipment 116, various types of known cleaning equipment can be used depending on the material and size of the plates 122 and the shape of the pattern portions 122A, and the typical cleaning equipment which can be suitably used include, for example, ultrasonic cleaning equipment, oxygen plasma cleaning equipment, high pressure jet spray cleaner and scrub cleaner. Various types of plate cleaning equipment 116 can be used if they do not scratch or deform the plates 122.

As the cleaning fluid used in the plate cleaning equipment 116, various type of known fluids, such as deionized water, various types of detergents and organic solvents, can be employed depending on the material and size of the plates 122, the shape of the pattern portions 122A, etc.

As the plate drying equipment 118, various types of known equipment, such as hot air drier, drying equipment using radiational heating by far infrared rays, vacuum drying equipment and solvent vapor drying equipment, can be used. The plate drying equipment 118 of this embodiment shown in Fig. 9 comprises: a hydro-removing zone 118A in which moisture on the plates 122 is blown away by air-knife injected from nozzles 130, 130; a hot air drying zone 118B in which the plates 122 are dried by hot air; and a cooling zone 118C in which the plates 122 are cooled to room temperature. As in the case of this embodiment, preferably the plates 122 are cooled to room temperature before using.

The air-knife is not an indispensable constituent requirement. The cooling zone 118C is not an indispensable constituent requirement, either, when the set temperature of the hot air drying zone 118B is low.

In Fig. 9, each plate 122 is supported with a conveyer 132 and allowed to move through the zones. In the hot air drying zone 118B and the cooling zone 118C, hot air injecting faces 134, 134 and cool air injecting faces 136, 136 are formed on the upper and lower sides of the carrying path so that the plates 122 can be dried and cooled.

As the coating apparatus (coating device) 112, various types of known devices can be employed. In particular, application type of devices, such as roller coater, dip coater and fountain coater, and metering type of devices, such as air-knife coater, blade coater and bar coater, are applicable. Further, devices, such as extrusion coater, slide bead coater and curtain coater, are also applicable which take charge of both application type and metering type of coating.

As the coating apparatus (coating device) 112 shown in Fig. 7, a roller coater is employed. In this roller coater, when the plates 122 move in the direction shown by the arrow at a specified speed under an applicator roll 112A rotating in the direction shown in the drawing, the pattern material P is applied on the pattern portions 122A of the respective plates 122 to a fixed thickness. On the backside of the applicator roll 112A, a metering roll 112B is provided so that the amount of the pattern material P fed to the applicator roll 112A is controlled to be uniform.

A single coating apparatus 112 may be used to apply various types of pattern materials P on the plates 122; however, it is preferable in terms of productivity (e.g. job change and cleaning of the apparatus), quality control (e.g. avoiding the inclusion of the pattern materials P) and improvement in yield to prepare one coating apparatus 112 for every type of pattern material P. In the apparatus 100 for manufacturing pattern members of this embodiment, four coating apparatuses 112 are provided which correspond to pattern materials P for red (R), green (G), blue (B) and an insulation layer (I).

As aforementioned, the system of the coating apparatus 112 does not matter as long as it can apply pattern materials P on the pattern portions 122A of the plate 122 to a fixed thickness. Film forming methods, which belong to a superior concept, other than the above-described coating methods such as deposition method can also be employed.

The plates 122 on which the pattern materials P have been applied are sent to coating liquid drying equipment (drying device) 114 so that the pattern materials P are dried. As the coating liquid drying equipment 114, various types of known equipment such as hot-air circulating drying equipment, drying equipment using radiational heating by far infrared rays and vacuum drying equipment can be used.

When the pattern materials P are used for luminescent layers of OLED, since the luminescent layers are less resistant to foreign particles and moisture and their product life is largely affected, they should be sufficiently dried. In this case, it is preferable to store plurality of plates 122 in, for example, hot-air circulating drying equipment (clean oven) and deal with them in sequence in accordance with first-in first-out system. Doing this ensures good production efficiency. In the apparatus 100 for manufacturing pattern members of this embodiment, two pieces of coating liquid drying equipment 114 are provided, as shown in Fig. 8.

In the above-described sequence of processes, it is preferable in terms of the products' quality (e.g. dust-free) and production efficiency that the plates 122 are automatically handled by a first carrying equipment 126 shown in Fig. 8. As the first carrying equipment 126, known automatic warehouse robots can be used. The flow of the plates 122 is shown by the arrows in Fig. 8.

Preferably, the above-described sequence of processes are carried out under the environmental conditions of satisfactory dust-freedom and optimum temperature/humidity. Accordingly, it is preferable to carry out the processes in a clean room, and it is particularly preferable to position the coating device 112 and the drying device 114 in the environment of cleanliness class 100 or less. To accomplish this, the method can employ a down flow clean room or a clean bench.

Particularly when the pattern materials P are used for luminescent layers of OLED, it is preferable to hold them in a low-humidity environment since the product life of the luminescent layers is largely affected by moisture. In particular, it is preferable to hold them in air or in a nitrogen gas atmosphere at minus 20°C or lower. It is also preferable to decrease the relative humidity (RH) as much as possible.

The plates 122 having been dried in the coating liquid drying equipment (drying device) 114 are automatically handled by the first carrying equipment 126 and carried to a second carrying equipment 128. The second carrying equipment 128 is so constructed that it can freely move right and left in Fig. 8 and receives the plates 122 from the first carrying equipment 126 and feeds the same to transfer equipment (transferring device) 124. As the second carrying equipment 128, various types of known carrying devices can be employed.

The transfer equipment (transferring device) 124 used in the transfer process transfers the pattern materials P to the substrate B by superposing and positioning one of the plates 122 on the substrate B in such a manner as for the patterns to come in contact with the substrate B and then pushing the substrate B and/or the plates 122 from their backs.

As the material for the substrate B fed in this transfer process, a glass plate (for, for example, color filters of liquid crystal displays), a silicon substrate, a metal plate, etc. can be used. For OLED elements, the substrate B using the aforementioned flexible support strip is preferably used.

In the following, the embodiment using the substrate B of a flexible support strip will be described. In the block diagram of the transferring device 124 shown in Fig. 10, the substrate B of a flexible support strip is unwound from a roller 142 in an unwind zone (UW section) 140, passed through a dust-removing zone 146 comprising a dust remover etc., and sent to an alignment/transfer zone 150. In this alignment/transfer zone 150, the pattern materials P are transferred to the substrate B. Then, the substrate B is passed through an EPC (edge position controlling equipment) 154 in a wind-up zone (W section) 156 and wound up around a roller 158.

In the transferring device 124, suction rollers 144, 148 and 152 are sectional drive system of rollers which can carry the substrate B of a flexible support strip while sucking and holding the same, and the tension of the substrate B can be determined in front of and behind the suction rollers 144, 148 and 152.

Dancer rollers 157, 159 are to control the tension of the substrate B of a flexible support strip and the rotational speed of the suction rollers 144, 148 and 152, and they can apply an arbitrary tension to the substrate B of a flexible support strip by the use of an air cylinder etc. Further, the dancer rollers 157, 159 can control the carrying speed of the substrate B of a flexible support strip at a fixed rate (feedback control can be done) by varying the positions of the dancer rollers.

In the dust-removing zone 146, the dust remover removes dust attached on the substrate B of a flexible support strip. In this removing operation, air at pressure about 10 kPa is blown on the substrate, and the air and the dust are collected. At this point, if tension of about 10 kg/m is not applied to the substrate B of a flexible support strip, the substrate B loses the support, which may cause the substrate's snaking.

On the other hand, taking into consideration that the substrate B is aligned with the plates 122 with a high accuracy in the alignment/transfer zone 150, it is preferable to keep the tension applied to the substrate B small. In other words, it is preferable in terms of high-accuracy alignment to avoid the elastic deformation of the substrate B as much as possible. Particularly when the substrate B is sucked and held by the substrate-supporting base 160, it is preferable not to apply tension to the substrate B.

In the wind-up zone (W section) 156, if the plane pressure applied to the substrate B (pressure perpendicular to the plane of the substrate B) is too high at a time when the substrate B of a flexible support strip is wound up, the pattern materials P having been transferred to the substrate B can sometimes be adversely affected; accordingly, it is preferable to keep the plane pressure applied to the substrate B at a certain value or less. It is also preferable to control the tension applied to the substrate B so that the wind-up torque is always kept constant even when the turn diameter of the roller 158 is increased.

As described so far, preferable tension applied to the substrate B differs among the dust-removing zone 146, alignment/transfer zone 150 and wind-up zone (W section) 156. Accordingly, it is preferable to control the tension applied to the substrate B in every zone. Such control is performed with the suction rollers 144, 148 and 152 and the dancer rollers 157 and 159. As devices which controls the carrying speed of the substrate B and the tension applied to the substrate B, other known devices can also be employed, instead of the suction rollers 144, 148 and 152 and the dancer rollers 157 and 159.

The substrate B of the flexible support strip may be provided with a cathode/an electron-carrying layer by, for example, sputtering or vacuum evaporation process so that it has a barrier function, or it may be provided with an anode which supplies positive holes for the organic film. The details of the cathode and anode will be described later.

The transfer equipment (transferring device) 124 shown in the drawing is prepared to comply with the substrate B of a flexible support strip, however, the basic construction of the transfer equipment for the substrate B of a plate material, such as glass plate, silicon substrate or metal plate, is almost the same as that of the substrate B of a flexible support strip, except for the carrying device.

Then the details of the alignment/transfer zone 150 will be described with reference to Fig. 7. The alignment/transfer zone 150 is made up of: a plate supporting base, not shown in the drawing, which aligns the plates 122 in the X, Y, Z and θ directions while supporting the same; a substrate supporting base 160 whose surface (bottom surface) is made flat so that it sucks and supports the back (top surface) of the substrate B; two or more positioning detecting devices (omitted in the drawing) which are provided in the vicinity of both ends of each plate 122 so that they can position the plates 122 and which can detect the positioning marks or the pattern portions 122A of the plates 122; and a pushing device (omitted in the drawing) which pushes the substrate B and/or the plates 122 from their back to transfer the pattern materials P on the substrate B.

An aligning device in the substrate-supporting base 160 which aligns the plates 122 in the X, Y, Z and θ directions can be constructed using aligning devices commonly in use, for example, constructed using a combination of a ball screw with a stepping motor. An sucking/supporting device which sucks/supports the substrate B in the substrate supporting base 160 can be constructed as a combination of a plurality of fine vacuum suction openings provided on the surface of the substrate supporting base 160 with a suction device (e.g. rotary vacuum pump) in communication with the vacuum suction openings. The positioning detecting devices can be constructed by combining a microscope or a digital camera with a CRT monitor connected thereto.

As the pushing device, can be employed pushing devices commonly in use; for example, devices constructed as a combination of an air cylinder with a regulator can be employed to push the entire face of the substrate B and/or the plates 122. Instead of using devices which are constructed to push the entire face of the substrate B and/or the plates 122, a pushing method can also be employed which uses roller members to push the substrate B and/or the plates 122 serially or linearly. In other words, devices can be used which are constructed to move roller members while pushing the substrate B and/or the plates 122 from their back with the roller members.

The alignment may be done by a manual system in which an operator aligns the plates 122 in the X, Y, Z and θ directions with an aligning device while reading the detecting results obtained by the positioning detecting devices or by an automatic system in which alignment of the plates 122 in the X, Y, Z and θ directions is automatically done according to the detecting results obtained by the positioning detecting devices.

First, the substrate supporting base 160 in the state shown in Fig. 7 descends to the position where it almost comes in contact with the back (top surface) of the substrate B to suck/support the substrate B. Then, the plate supporting base supports (e.g. vacuum sucks) the plates 122 and aligns the same in the X, Y, Z and θ directions while allowing them to be in close proximity to and in opposition to the substrate B.

At a time when the alignment is completed, the substrate B and/or the plates 122 are pushed from their back with a pushing device to transfer the pattern material P to the substrate B. Preferably the alignment/transfer zone 150 is constructed so that, when transferring the pattern material P, a specified pressure is applied to the pattern material P depending on the shape and the material thereof and a specified heat is applied to the same depending on the situation. For example, a construction can be employed in which a sheath heater, as a heating device, is provided for the substrate-supporting base 160.

At a time when the transfer of a first kind of pattern material P is completed, the substrate supporting base 160 and the substrate B supported thereby are kept in a stand-by condition as they are. Then, the first kind of plate 122 is replaced with a second kind of plate 122. In this replacing operation, the second kind of plate 122 is positioned so that it is shifted one pitch of the striped or matrix pattern.

The alignment of the second and subsequent kinds of plates 122 is done while reading the alignment marks formed in the vicinity of both ends of each plate 122 with positioning detecting devices or reading the first kind of pattern material P having been formed on the substrate B with positioning detecting devices so that they are held in position relative to the first pattern material P having been formed on the substrate B. After these operations are conducted for every type of plate 122, the transfer of the pattern materials P to the substrate B is completed.

When doing alignment while reading the first kind of pattern material P with positioning detecting devices, if part of the substrate supporting base 160 is formed of a transparent material or part of the same is cut away, the first kind of pattern material P can be conveniently read with positioning detecting devices through the substrate supporting base 160.

When using the plate-supporting base to support (e.g. vacuum suck) the plates 122, preferably a construction is employed in which three points on the plate-supporting base are provided with positioning pins so that each plate 122 can be held in the same position by pressing two sides of the plate 122 against the positioning pins. Similarly, a construction can also be employed in which the aligning positions of the plate supporting base and the plates 122 are provided with penetrations and the penetrations are connected with penetrating pins (in this case tapered pins are preferable) to position the plates 122.

When the positioning accuracy of the pattern materials P can be rough, the positioning can be done without employing the above-described positioning detecting device, but with the above positioning pins alone.

After completing the transfer process, the substrate B is passed through the suction roller 152 and EPC 154 so that the adhesion of the pattern materials P to the substrate B is ensured, as aforementioned, and wound up around the roller 158 in the wind-up zone (W section) 156.

In the following, the flow of the manufacturing the substrate B using the apparatus 100 for manufacturing pattern members will be described. New plates 122 or plates 122 having undergone the transfer process are cleaned/dried with plate cleaning equipment 116 and plate drying equipment 118, and carried to the respective coating apparatuses 112 (coating apparatuses 1 to 4) which correspond to the respective pattern materials P. In this operation, in the plate drying equipment 118, the plates 122 is subjected to hydro-removing in the hydro-removing zone 118A, dried at proper temperature of 100 to 300°C in vacuum in the hot air drying zone 118B, and cooled to room temperature in the cooling zone 118C.

In the coating apparatus 112, the pattern materials P are applied on the pattern portions 122A of the plates 122 to a specified thickness with the applicator roll 112A. The requirements of the film applied are such that, for example, liquids containing the respective pattern materials P and having a viscosity of several tens mPa·s are applied on the pattern portions 122A to a film thickness of the order of µm or sub µm. This film thickness is decreased to about 1/30 after drying. Preferably, variation in film thickness at the time of applying coating liquids is restricted within ±5%.

The plates 122 having been coated with coating liquids are sent to the coating liquid drying equipment 114 so that the pattern materials P are dried. The drying conditions can be selected depending on the composition of the coating liquids; however, when the solvent of the coating liquids is water, it is preferable to carry out drying in vacuum at 50 to 150°C for 3 minutes or longer. The plates 122 having been dried are sent to the transfer equipment 124.

When the substrates B supplied in the transfer equipment 124 is a flexible support strip and has a barrier function which is a cathode/electron transporting layer having been formed in advance by sputtering, vacuum evaporation, etc. using a separately provided apparatus, the following construction, for example, can be employed.

In the transfer equipment 124, each of the pattern materials P is transferred to the substrate B by superposing and positioning one of the plates 122 on the substrate B in such a manner as for the pattern material P to come in contact with the substrate B and pushing the substrate B and/or the plate 122 from their back, as aforementioned. A plurality of kinds of pattern materials P are transferred to the substrate B by repeating this operation for every pattern material P.

In this transfer operation, when transferring a first kind of pattern material P, the plate 122 need not be positioned exactly as long as it is arranged in parallel with the substrate B. When transferring a second and subsequent kinds of pattern materials P, it is important, in terms of yielding high-accuracy products, to position the plates 122 exactly.

The transfer conditions must be selected optimally depending on the materials of the pattern materials P and the substrate B. As to the pushing force at the time of transferring, when pushing is done, for example, linearly using roller members (elastic rollers such as rubber rollers), linear pressures in the range of 0.5 to 5 kg/cm can be employed.

As to the heating temperature at the time of transferring, generally temperatures in the range of 40 to 250°C are preferably employed, and those in the range of 60 to 180°C are more preferably employed. Keeping the residual heat in the plates 122 and/or the substrate B (substrate supporting base 160) is preferable because it improves the productivity.

After completing the transfer process, the substrate B is passed through the suction roller 152 and EPC (edge position controlling equipment) 154 so that the adhesion of the pattern materials P to the substrate B is ensured, as aforementioned, and wound up around the roller 158 in the wind-up zone (W section) 156. At the same time, the plates 122 are carried to the plate cleaning equipment 116 and repeatedly used.

Figs. 5(a) and 5(b), though it has already been described above, is a block diagram showing a substrate B on which the pattern materials P have been transferred. On the surface of the substrate B, patterns of three kinds (R, G and B) of pattern materials P having a fixed width and a fixed pitch are formed repeatedly.

While the present invention has been described in terms of its preferred embodiments of methods and apparatus for manufacturing pattern members, these embodiments are shown for illustrative purposes only and are not intended to limit the present invention and a variety of other embodiments are possible.

For example, a variety of embodiments other than the above can be selected if changes are made in: types and number of plates 122; number and layout of coating apparatus 112, coating liquid drying equipment 114, etc.; and arrangement of carrying equipment, depending on the product size of the pattern members, the types of the products and the amount of the products.

Further, in the transfer equipment 124, instead of the construction in which the subsequent plate 122 is positioned so that it is shifted one pitch of the striped or matrix pattern, a construction may be selected in which the substrate supporting base 160 (substrate B) is positioned so that it is shifted one pitch of the striped or matrix pattern.

### EXAMPLES

### Example 1

In the following, examples of coating methods embodying the present invention will be described. A coating film was applied on a web 12 using a coating apparatus 10 shown in Figs. 1 to 3, and the conditions of the coated surface were evaluated.

As a web 12, a PET film 0.02 mm thick was used. As a coating liquid, a liquid was used in which a pigment, a binder, ethanol and a coating auxiliary were mixed and dispersed and of which viscosity was adjusted to 7 mPa·s. The coating width and the coating thickness (in the wet state) were set for 1 m and 20 µm, respectively, and coating was performed while changing the carrying speed U (unit: m/min) of the web 12. The viscosity 7 mPa·s of the coating liquid and the coating thickness (in the wet state) 20 µm described above were set so that the coating thickness after drying became 0.1 µm. After the coating, the relative airflow rate V₀ (unit: m/sec) on the surface of the coating film between the coating head 18 and the drying equipment 30 and the relative airflow rate V₁ (unit: m/sec) on the surface of the coating film in the drying equipment 30 were measured with a hot-wire anemometer, respectively. The measurement was done with the hot-wire anemometer fixed on the web 12. The web 12 used in this measurement was a dummy, and the evaluation of the coated surface conditions was performed using another web 12 which had been dried under the same conditions.

As the viscosity ρ (unit: mPa·s) of the coating film at the position where the web 12 just came out of the drying equipment 30, first the evaporation loss of the coating film was obtained, then a liquid of the coating film was prepared by forcibly evaporating the same offline, and the viscosity of the liquid was measured with a B-type viscometer.

In the drying equipment 30, the internal atmospheric temperature was set for 100°C and the temperature of the infrared heater 34, 34 were set for 200°C. In one of comparative examples (example 5), the heater 34, 34 were set at OFF. Further, in comparative examples, all or part of the shielding plate was removed so that the relative airflow rate V₁ on the surface of the coating film was increased.

In the drying equipment 32, the internal atmospheric temperature was set for 80°C and the airflow rate in the inside of the drying equipment 32 was set for 3 to 5 m/sec.

The conditions of the coated surfaces were evaluated by conducting sensory inspection visually mainly of coating non-uniformity. The coated surfaces of good conditions were graded "A", those of the marginal conditions "B", and those of apparent non-uniformity "F". The above-described parameters, measured values, and the results of the evaluation are summarized in Table 1.

**Table 1**

| | ρ | U | V₀ | V₁ | Heater | Evaluation of Film |
|---|---|---|---|---|---|---|
| Example 1 | 116 | 10 | 0.1 | 0.16 | ON | A |
| Example 2 | 116 | 2 | 0.1 | 0.16 | ON | A |
| Example 3 | 133 | 10 | 0.1 | 0.23 | ON | B |
| Example 4 | 161 | 10 | 0.1 | 0.41 | ON | F |
| Example 5 | 82 | 8 | 0.1 | 0.18 | OFF | B |

In Table 1, examples 1 and 2 are coating methods in which coating films are made under the conditions within the scope of the present invention, and examples 3 to 5 are shown as comparative examples. Specifically, examples 3 and 4 are coating methods in which the relative airflow rate V₁ on the surface of the coating film in the drying equipment 30 is outside the scope of the present invention, while example 5 is a coating method in which the viscosity ρ of the coating film at the position where the web 12 just comes out of the drying equipment 30 is outside the scope of the present invention.

Comparing the evaluation results shown in Table 1, satisfactorily coated surfaces were obtained in examples 1 and 2 as embodiments of the present invention, in contrast with marginally coated surfaces, due to overall drying non-uniformity, for examples 3 and 5 as comparative examples. In example 4 as a comparative example, the coated surface obtained was poor due to its remarkable drying non-uniformity.

It is presumed that the drying non-uniformity in example 3 was caused by the high relative airflow rate V₁ on the surface of the coating film.

It is presumed that the remarkable drying non-uniformity in example 4 was caused by the significantly high relative airflow rate V₁ on the surface of the coating film.

It is presumed that the drying non-uniformity in example 5 was caused by the fact that since the infrared heaters 34, 34 were set at OFF, the drying speed became low, and the web 12 entered the drying equipment 32 with the viscosity p of its coating film still low.

### Example 2

In the following, examples of coating methods embodying the present invention will be described. A coating film was applied on a web 12 using a coating apparatus 10 shown in Figs. 1 to 3, and the conditions of the coated surface were evaluated.

As a web 12, a PET film 0.02 mm thick was used. As a coating liquid, a liquid was used in which a pigment, a binder, ethanol and a coating auxiliary were mixed and dispersed and of which viscosity was adjusted to 7 mPa·s. The coating width and the coating thickness (in the wet state) were set for 1 m and 30 µm, respectively, and coating was performed while changing the amount A (unit: ml/sec) per cm width of the coating liquid fed, the distance t (unit: mm) from the tip of the coating head 18 to the surface of carrying speed U (unit: m/min) of the web 12.

The viscosity 7 mPa·s of the coating liquid and the coating thickness (in the wet state) 30 µm described above were set so that the coating thickness after drying became 0.2 µm.

The conditions of the coated surfaces were evaluated by conducting sensory inspection visually mainly of coating non-uniformity. The coated surfaces of good conditions were graded "A", those of the marginal conditions "B", and those of apparent non-uniformity "F". The above-described parameters, measured values, and the results of the evaluation are summarized in Table 2.

**Table 2**

| | A | T | D | H | U | V | T | Evaluation of Face |
|---|---|---|---|---|---|---|---|---|
| Example 11 | 0.12 | 0.10 | 240 | 120 | 24 | 120 | 0.47 | A |
| Example 12 | 0.24 | 0.06 | 240 | 120 | 48 | 400 | 0.24 | A |
| Example 13 | 0.12 | 0.20 | 200 | 100 | 24 | 60 | 0.39 | F |
| Example 14 | 0.12 | 0.04 | 200 | 100 | 24 | 600 | 0.39 | B |
| Example 15 | 0.12 | 0.10 | 300 | 150 | 24 | 120 | 0.58 | B |

In Table 2, the vertical distance H (unit: mm, shown in Fig. 1) from the tip of the coating head 18 to the top portion of the back-up roller 20, the average flow rate V (unit: mm/sec) of the coating liquid in the slit 18C of the coating head 18, and the time T (unit: sec) required for the web 12 to be held in a horizontal state after the coating are inevitably determined by the set parameters and the construction of the coating apparatus 10.

In Table 2, examples 11 and 12 are coating methods in which coating films are made under the conditions within the scope of the present invention, and examples 13 to 15 are shown as comparative examples. Specifically, examples 13 and 14 are coating methods in which the average flow rate V of the coating liquid in the slit 18C of the coating head 18 is outside the scope of the present invention, while example 15 is a coating method in which the time T required for the coating web 12 to be held in a horizontal state is outside the scope of the present invention.

Comparing the evaluation results shown in Table 2, satisfactorily coated surfaces were obtained in examples 11 and 12 as embodiments of the present invention, in contrast with marginally coated surfaces, due to overall drying non-uniformity, for examples 14 and 15 as comparative examples. In example 13 as a comparative example, the coated surface obtained was poor due to its remarkable drying non-uniformity in the width direction.

### Example 3

In the following, the materials etc. used when producing OLED elements according to the present invention will be described in details. The substrate B may be made up of: for example, an inorganic material such as yttria stabilized with zirconia (YSZ) or glass; polyester such as polyethylene terephthalate, polybutylene terephthalate or polyethylene naphthalate; a macromolecular material such as polystyrene, polycarbonate, polyether sulfone, polyallylate, allyldiglycol carbonate, polyimide, polycycloolefin, norbornene resin, polychlorotrifluoroethylene, Teflon (registered trademark) or polytetrafluoroethylene-polyethlene copolymer; metal foil such as aluminum foil, copper foil, stainless foil, gold foil or silver foil; or a plastic sheet of polyimide or liquid crystal polymer.

In this embodiment, from the viewpoint of resistance to fracture, ease of bending and lightness in weight, it is preferable to use a flexible substrate B. As a material for forming such a substrate B, polyimide, polyester, polycarbonate, polyether sulfone, metal foil (e.g. aluminum foil, copper foil, stainless foil, gold foil or silver foil), a plastic sheet of liquid crystal polymer or a fluorine-containing macromolecular material (polychlorotrifluoroethylene, Teflon (registered trademark) or polytetrafluoroethylene-polyethlene copolymer) is preferably used which is excellent in resistance to heat, dimensional stability, resistance to solvents, electrical insulation properties and processability and low in gas permeability and moisture absorption.

The shape, structure, size, etc. of the substrate B can be appropriately selected depending on the applications and purposes of the organic thin film elements. The structure may be a single-layer structure or a laminated structure. The substrate B may be formed of a single member or two or more members. Further, the substrate B may be transparent or opaque. However, when taking out luminescence from the support side for the reason that a transparent electrode, which will be described later, is positioned on the substrate B side relative to an organic layer that includes a luminescent layer, the substrate B is preferably colorless and transparent or colored and transparent, and from the viewpoint of inhibiting light from scattering and attenuating, the substrate B is preferably colorless and transparent.

As a flexible substrate B which is not short-circuited even when forming an electrode and producing a luminescent element, is preferable a substrate B which is made up of metal foil and provided with an insulating layer on one side or both sides of the metal foil. The kind of the metal foil used is not particularly limited, and any metal foil such as aluminum foil, copper foil, stainless foil, gold foil or silver foil can be used. However, from the viewpoint of ease of processing and costs, aluminum foil or copper foil is particularly preferably used.

The insulating layer is not particularly limited to any specific one, and it can be formed of: for example, an inorganic material such as inorganic oxide or inorganic nitride; polyester such as polyethylene terephthalate, polybutylene terephthalate or polyethylene naphthalate; or plastic such as polystyrene, polycarbonate, polyether sulfone, polyallylate, allyldiglycol carbonate, polyimide, polycycloolefin, norbornene resin, polychlorotrifluoroethylene or polyimide.

Preferably, the substrate B has a coefficient of linear thermal expansion of 20 ppm/°C or less. The coefficient of linear thermal expansion is determined in such a manner as to detect the changes in length of a specimen while heating the same at a fixed rate and mainly by TMA method. The coefficient of linear thermal expansion more than 20 ppm/°C contributes to the peeling off of the electrode and the organic thin film layer from the substrate, when the substrate is heated during the bonding process or at the time of use, and hence to the deterioration of the substrate's durability.

Preferably, the insulating layer provided on the substrate B also has a coefficient of linear thermal expansion of 20 ppm/°C or less. As materials for forming the insulating layer having a coefficient of linear thermal expansion of 20 ppm/°C or less, are preferably used metal oxides such as silicon oxide, germanium oxide, zinc oxide, aluminum oxide, titanium oxide and copper oxide; and metal nitrides such as silicon nitride, germanium nitride and aluminum nitride, and one kind of the above materials independently or two or more kinds of the same in combination can be used as the materials.

Preferably, the thickness of the inorganic insulating layer of metal oxide and/or metal nitride is 10 nm to 1000 nm. If the thickness of the inorganic insulating layer is less than 10 nm, the insulating properties become too low, whereas if the thickness of the inorganic insulating layer is more than 1000 nm, cracks are likely to occur in the insulating layer, which causes pinholes in the same and results in low insulating properties.

The processes for forming the insulating layer of metal oxide and/or metal nitride are not limited to any specific ones, and dry processes such as sputtering process and CVD process, wet processes such as sol-gel processing, or a process in which particles of metal oxide and/or metal nitride are dispersed in a solvent and applied to the one or both sides of the metal foil can be used.

As a plastic material having a coefficient of linear thermal expansion of 20 ppm/°C or less, polyimide and liquid crystal polymer can be particularly preferably used. The details of these plastic materials are described in, for example, "Plastics Data Book" (edit. by an editorial department of "Plastics", Asahi Kasei AMIDAS)

When using polyimide etc. for the insulating layer, it is preferable to laminate a sheet of polyimide etc. and aluminum foil. Preferably, the thickness of the sheet of polyimide etc. is 10 µm to 200 µm. If the thickness of the sheet of polyimide etc. is less than 10 µm, the handling of the sheet becomes difficult at the time of laminating, whereas if the thickness of the sheet of polyimide etc. is more than 200 µm, the flexibility of the sheet deteriorates and the handling of the same becomes inconvenient.

The insulating layer may be provided for only one side of the metal foil or for both sides of the same. When providing the insulating layer for both sides of the metal foil, both the sides may be provided with the insulating layer formed of metal oxide and/or metal nitride or with the insulating layer formed of plastic such as polyimide. Alternatively, one side of the metal foil is provided with the insulating layer of metal oxide and/or metal nitride and the other side with the insulating layer of polyimide sheet. A hard coat layer or an under coat layer may also be provided, depending on the situation.

A moisture permeation preventive layer (gas barrier layer) may also be provided on the electrode side surface of the substrate B or on the opposite side surface of the same, or on both the surfaces. As a material constituting the moisture permeation preventive layer, preferably an inorganic material such as silicon nitride or silicon oxide is used. The moisture permeation preventive layer can be formed by radiofrequency sputtering process etc. The substrate B may be provided with a hard coat layer or a under coat layer, depending on the situation.

Preferably, the substrate B is made up of metal foil and provided with an insulating layer on one side or both sides of the metal foil. The kind of the metal foil is not particularly limited to any specific one. Metal foil such as aluminum foil, copper foil, stainless foil, gold foil or silver foil can be used. From the viewpoint of ease of processing and costs, aluminum foil or copper foil is particularly preferably used.

The insulating layer is not particularly limited to any specific one, and it can be formed of: for example, inorganic material such as inorganic oxide or inorganic nitride; polyester such as polyethylene terephthalate, polybutylene terephthalate or polyethylene naphthalate; or plastic such as polystyrene, polycarbonate, polyether sulfone, polyallylate, allyldiglycol carbonate, polyimide, polycycloolefin, norbornene resin, polychlorotrifluoroethylene or polyimide.

Preferably, the moisture permeability of the substrate B is 0.1 g/m²·day or less, more preferably 0.05 g/m²·day or less, and particularly preferably 0.01 g/m²·day or less.

Preferably the oxygen permeability of the substrate B is 0.1 ml/m²·day·atm or less, more preferably 0.05 ml/m²·day·atm or less, and particularly preferably 0.01 ml/m²·day·atm or less.

The moisture permeability can be determined by the method in accordance with JIS K7129B (mainly MOCON method). The oxygen permeability can be determined by the method in accordance with JIS K7126B (mainly MOCON method). Restricting the moisture permeability and oxygen permeability of the substrate B within the above range permits the prevention of water or oxygen, which are the cause of deterioration of element's durability, from entering the luminescent element.

Of the electrodes processed on the substrate B, either the transparent electrode or the backside electrode can be used as a cathode or an anode. Which is a cathode or an anode depends on the composition constituting the organic thin film element. As to the anode, its shape, structure, size, etc. are not particularly limited as long as it functions as an anode which supplies holes (positive holes) to the organic thin film layer, and it can be appropriately selected from publicly known electrodes, depending on the applications and purposes of the luminescent elements.

As a material for forming the cathode, metal as a simple substance, an alloy, metal oxide, an electrically conductive compound, or the mixture thereof can be used, and preferably a material whose work function is 4.5 eV or less can be used. Concrete examples include, for example, alkali metals (e.g. Li, Na, K, Cs), alkali earth metals (e.g. Mg, Ca), gold, silver, lead, aluminum, sodium-potassium alloys, lithium-aluminum alloys, magnesium-silver alloys, indium, rare earth metals (e.g. ytterbium). Each one of these materials may be used alone; however, from the viewpoint of stability and electron injecting properties, preferably two or more kinds of the materials are used in combination.

Of the above materials, from the viewpoint of electron injecting properties, alkali metals and alkali earth metals are preferable, and from the viewpoint of storage stability, materials including aluminum as a main constituent are preferable. The term "materials including aluminum as a main constituent" herein used means not only aluminum as a simple substance, but also the alloy or the mixture of aluminum and 0.01% by weight to 10% by weight of alkali metal or the alloy of aluminum and 0.01% by weight to 10% by weight of alkali earth metal (e.g. lithium-aluminum alloy, magnesium-aluminum alloy) or the mixture of the same.

When taking out light from the cathode side, a transparent cathode must be used. As a transparent electrode, any electrodes can be used as long as they are substantially transparent to light. To allow the electron injecting properties and the transparency to be compatible with each other, the cathode is allowed to have a two-layer structure which comprises a metal layer as a thin film and a transparent conductive layer. The materials for the thin film metal layer are described in detail in Japanese Patent Application Publication Nos. 2-15595 and 5-12117. Preferably, the thickness of the thin film metal layer is 1 nm to 50 nm. If the thickness is less than 1 nm, it becomes difficult to form a thin film layer uniformly, whereas if the thickness is more than 50 nm, the transparency to light deteriorates.

As a material used for the transparent conductive layer, not limited to any specific one any materials used for the above-described anode can be preferably used as long as they are electrically conductive or semi-conductive materials. Preferable materials include, for example, antimony- or fluorine-doped tin oxide (ATO, FTO), tin oxide, zinc oxide, indium oxide, indium tin oxide (ITO) and indium zinc oxide (IZO).

Preferably, the thickness of the transparent conductive layer is 30 nm to 500 nm. If the thickness of the transparent conductive layer is less than 30 nm, the conductivity or semi-conductivity deteriorate, whereas if the thickness of the transparent conductive layer is more than 500 nm, the productivity is decreased.

The process for forming the cathode is not limited to any specific one, any known processes can be used. Preferably, the cathode is formed in vacuum equipment. The process can be selected from the physical processes, such as vacuum deposition process, sputtering process and ion plating process, and chemical processes, such as CVD process and plasma CVD process, taking into consideration the suitability for the cathode materials. For example, when selecting metal etc. as a material for the cathode, the cathode can be formed by sputtering one kind of or two or more kinds of metal at one time or one by one. When using an organic conductive material, a wet film forming process may be used.

The cathode can be patterned by chemical etching using photolithography etc., physical etching using laser etc., vacuum deposition process or sputtering process using a mask, or lift off method or printing method.

A dielectric layer of alkali metal fluoride or alkali earth metal fluoride with thickness 0.1 nm to 5 nm may be inserted between the cathode and the organic thin film layer. The dielectric layer can be formed by, for example, vacuum deposition process, sputtering process or ion plating process.

A pattern member was produced in accordance with the process shown in Figs. 7 to 10. As plates 22, three relief plates were used, and R, G and B inks for OLED elements were applied to the plates. The thickness of the inks applied was adjusted so that it becomes 0.05 µm when it is in the dried state.

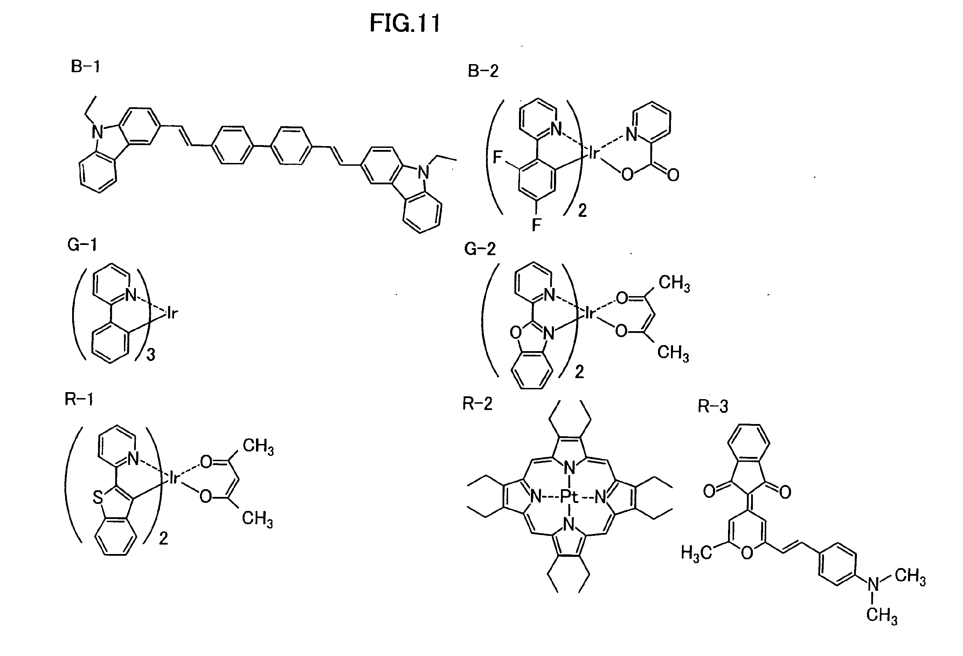

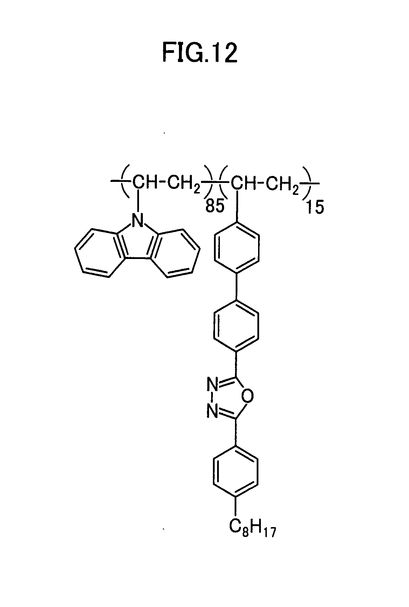

The compositions of the R, G and B inks (pattern materials P) were as follows: 1 part by mass of each of the compounds 1 having the chemical formulas shown in Fig. 11, 40 parts by mass of the compound 2 (weight average molecular weight of 17000) having the chemical formula shown in Fig. 12, and 3200 parts by mass of dichloroethane.

Of these pattern materials, R ink (pattern material P) was selected from R-1, R-2 and R-3 of the compounds 1, G ink (pattern material P) was selected from G-1 and G-2 of the compounds 1, and B ink (pattern material P) was selected from B-1 and B-2 of the compounds 1.

Five combinations of different color inks were prepared from the above compounds 1 (refer to Table 3 described later) to perform pattern transfer.

As the substrate B, was used a polyimide film 50 µm thick (manufactured by Ube Industries, Ltd., Trade name: UPILEX-50S). After surface treating the substrate B, Al was vapor deposited over the substrate in a reduced pressure atmosphere of about 0.1 mPa to form an electrode 0.3 µm thick. Then, LiF was vapor deposited over the Al deposited substrate so as to form a dielectric layer of 3 nm thick in the same pattern as the Al layer.

The transfer of the pattern was performed in such a manner as to oppose the plate 22 and the substrate B to each other and apply a pressure of 12 MPa to them for 15 seconds with a substrate supporting base 60 which has been heated at 20°C, as shown in Fig. 7. This operation was repeated three times while aligning the plate 22 and the substrate B with each other.

The result of the pattern transfer was evaluated by visual observation with an optical microscope. Attention was restricted to the uniformity of patterning, and where there was observed no defect, the pattern transfer was considered to grade A and where there were observed defects, it was considered to grade P. The evaluation results were summarized in Table 3. Table 3 shows that the results were good in every combination of the color inks.

**Table 3**

| Selected Combinations of Compounds | | | Uniformity of Patterning |
|---|---|---|---|
| B Blue | G Green | R Red | |
| B-2 | G-1 | R-1 | A |
| B-1 | G-1 | R-1 | A |
| B-1 | G-1 | R-3 | A |
| B-2 | G-2 | R-1 | A |
| B-2 | G-2 | R-2 | A |

As described so far, according to the present invention, since the thickness of the coating film right after the application of the coating liquid is kept in a proper range and the relative airflow rate on the surface of the coating film is kept at 0.2 m/sec or less until the viscosity of the coating liquid becomes a specified value, an extremely thin film with high thickness accuracy and with a smooth surface can be obtained.

Further, according to the present invention, a plurality of different kinds of materials (R, G and B) can be transferred to a substrate in a pattern first by: applying the materials on the respective flexible support strips (transfer sheets) prepared for, for example, red (R), green (G) and blue (B); drying the transfer sheets; superposing one of the transfer sheets on the substrate, which is to be a product, in such a manner as for the material on the sheet to be in opposition to the substrate; and then pushing the transfer sheet from its back with a push plate. A pattern member (e.g. OLED element or color filter for liquid crystal display) can be formed if this operation is repeated for every material (R, G and B).

According to the present invention, since the average flow rate of the coating liquid in the slit of the coating head is kept in a proper range and the web is held in a horizontal position within a short time after the application of the coating liquid, an extremely thin film with high thickness accuracy and with a smooth surface can be obtained.

Further, according to the present invention, a plurality of different kinds of materials (R, G and B) can be transferred to a substrate in a pattern first by: applying the materials on the respective flexible support strips (transfer sheets) prepared for, for example, red (R), green (G) and blue (B); drying the transfer sheets; superposing one of the transfer sheets on the substrate, which is to be a product, in such a manner as for the material on the sheet to be in opposition to the substrate; and then pushing the transfer sheet from its back with a push plate. A pattern member (e.g. OLED element or color filter for liquid crystal display) can be formed if this operation is repeated for every material (R, G and B).

According to the present invention, a material in a pattern can be transferred to the substrate by: applying a plurality of different kinds of materials (R, G and B) in patterns on the respective plates on which patterns for, for example, red (R), green (G) and blue (B) have been formed; drying the plates; superposing and positioning one of the plates on a substrate, which is to be a product, in such a manner as for the pattern on the plate to come in contact with the substrate; and pushing the substrate and/or the plate from their backs. A pattern member (e.g. OLED element, color filter for liquid crystal display) can be formed, if this operation is repeated for every material (R, G and B).

Accordingly, the present invention can improve both the productivity and the product quality (pattern accuracy) in the manufacturing of pattern members in which a plurality of different kinds of materials are formed in patterns on substrates.

It should be understood, however, that there is no intention to limit the invention to the specific forms disclosed, but on the contrary, the invention is to cover all modifications, alternate constructions and equivalents falling within the spirit and scope of the invention as expressed in the appended claims.

## Claims

1. A coating method, comprising the steps of:
feeding and applying a coating liquid through a slit (18C) of a coating head (18) to form a coating film (28) of a specified thickness on a continuously running web (12) at a fixed distance apart from the coating head (18); and
subsequently drying the coating film (28) formed on the web (12),
wherein a thickness of the coating film (28) right after the applying step is set for 2 to 40 µm and a relative airflow rate on a surface of the coating film (28) is set for 0.2 m/sec or less until a viscosity of the applied coating liquid becomes 100 mPa·s.

2. The coating method according to claim 1, wherein a viscosity of the coating liquid in the applying step is 10 mPa·s or less.

3. The coating method according to claim 1, wherein the coating liquid contains an organic solvent.

4. The coating method according to claim 1, wherein a thickness of the coating film (28) after drying is 0.01 to 0.4 µm.

5. A coating method, comprising the steps of:
feeding and applying a coating liquid through a slit (18C) of a coating head (18) to form a coating film (28) of a specified thickness on a continuously running web (12) at a fixed distance apart from the coating head (18),
wherein an average flow rate of the coating liquid in the slit (18C) of the coating head (18) is set for 100 to 500 mm/sec, a thickness of the coating film (28) right after the applying step is set for 2 to 40 µm, and the web (12) is held in a horizontal position within 0.5 seconds after the applying step.

6. The coating method according to claim 5, wherein a viscosity of the coating liquid in the applying step is 10 mPa·s or less.

7. The coating method according to claim 5, wherein the coating liquid contains an organic solvent.

8. The coating method according to claim 5, wherein a thickness of the coating film (28) after drying is 0.01 to 0.4 µm.

9. A coating apparatus (10), comprising:
a coating head (18) having a slit (18C) through which a coating liquid is fed and applied to form a coating film (28) of a specified thickness on a continuously running web (12) at a fixed distance apart from the coating head (18); and
a drying device (10C) which subsequently dries the coating film (28) formed on the web (12), the drying device (10C) being capable of controlling a relative airflow rate on a surface of the coating film (28) to be 0.2 m/sec or less.

10. The coating apparatus (10) according to claim 9, wherein the drying device (10C) comprises at least one of a heater-heating drying device (34), a roller-heating drying device, a vacuum drying device and a low-humidity-atmosphere drying device.

11. A coating apparatus (10), comprising:
a coating head (18) having a slit (18C) through which a coating liquid is fed and applied to form a coating film (28) of a specified thickness on a continuously running web (12) at a fixed distance apart from the coating head (18),
wherein the coating apparatus (10) is capable of varying an average flow rate of the coating liquid in the slit (18C) of the coating head (18) within a range of 100 to 500 mm/sec, and holding the web (12) in a horizontal position within 0.5 seconds after the application of the coating liquid.

12. A method for manufacturing pattern members which uses webs (12R, 12G, 12B) having the respective coating films (28) formed thereon by the coating method according to any one of claims 1 to 8 and in which a plurality of different kinds of materials (P(R), P(G), P(B)) are formed in patterns on a substrate (B), comprising the steps of:
applying different kinds of materials (P(R), P(G), P(B)) on the respective webs (12R, 12G, 12B) prepared for the materials;
drying the webs (12R, 12G, 12B) on which the respective materials (P(R), P(G), P(B)) have been applied; and
repeating the operation, for every material (P(R), P(G), P(B)), of superposing one of the webs (12R, 12G, 12B) on the substrate (B) in such a manner as for the material (P(R), P(G), P(B)) having been applied on the web (12R, 12G, 12B) to be in opposition to the substrate (B) and pushing the web (12R, 12G, 12B) from its back with a push plate (40) so as to transfer the material (P(R), P(G), P(B)) to the substrate (B) in a pattern, so that the plurality of different kinds of materials (P(R), P(G), P(B)) are formed in patterns on the substrate (B).

13. The method for manufacturing pattern members according to claim 12, wherein the push plate (40) has protrusions (40A) formed in a pattern on its surface.

14. The method for manufacturing pattern members according to claim 12, wherein the plurality of different kinds of materials include materials (P(R), P(G), P(B)) for emitting lights or displaying which correspond to at least red (R), green (G) and blue (B).

15. The method for manufacturing pattern members according to claim 12, wherein the substrate (B) is a web.

16. A method for manufacturing pattern members in which a plurality of different kinds of materials (P) are formed in patterns on a substrate (B), comprising the steps of:
applying the different kinds of materials (P) on respective plates (122R, 122G, 122B, 122I) on which the patterns for the respective materials (P) have been formed;
drying the plates (122R, 122G, 122B, 122I) having the materials (P) applied on their surfaces; and
repeating, for every material (P), the operation of superposing and positioning one of the plates (122R, 122G, 122B, 122I) on the substrate (B) in such a manner as for the pattern (P) to come in contact with the substrate (B) and pushing the substrate (B) and/or the plate (122R, 122G, 122B, 122I) from their backs to transfer the pattern (P) to the substrate (B), so that the different kinds of materials (P) are formed in patterns on the substrate (B).

17. The method for manufacturing pattern members according to claim 16, wherein the plate (122R, 122G, 122B, 122I) has protrusions (122A) formed in a pattern on its surface.

18. The method for manufacturing pattern members according to claim 16, wherein the plurality of different kinds of materials (P) include materials for emitting lights or displaying which correspond to at least red (R), green (G) and blue (B).

19. The method for manufacturing pattern members according to claim 16, wherein the substrate (B) is a web.

20. The method for manufacturing pattern members according to claim 16, wherein the plates (122R, 122G, 122B, 122I) is capable of being repeatedly used if they are washed and dried after transferring the materials (P) having been formed into patterns to the substrate (B).

21. An apparatus for manufacturing pattern members in which a plurality of different kinds of materials (P) are formed in patterns on a substrate (B), comprising:
a coating device (112) which coats plates (122), on which patterns for different materials (P) have been formed, with the different materials (P);
a drying device (114) which dries the plates (122) whose surfaces have been coated with the materials (P); and
a transferring device (124) which transfers the patterns (P) to the substrate (B) by superposing and positioning one of the plates (122) on the substrate (B) in such a manner as for the pattern (P) to come in contact with the substrate (B) and pushing the substrate (B) and/or the plate (122) from their backs.
